Europäisches Patentamt

(19) European Patent Office

Office européen des brevets

(11) Numéro de publication : **0 015 789**
**B1**

# (12) FASCICULE DE BREVET EUROPÉEN

(45) Date de publication du fascicule du brevet :
**20.04.83**

(51) Int. Cl.³ : **G 03 B 41/00**, G 05 D 3/00

(21) Numéro de dépôt : **80400132.9**

(22) Date de dépôt : **28.01.80**

(54) **Dispositif optique de projection en photorépétition.**

(30) Priorité : **27.02.79 FR 7905008**

(43) Date de publication de la demande :
**17.09.80 Bulletin 80/19**

(45) Mention de la délivrance du brevet :
**20.04.83 Bulletin 83/16**

(84) Etats contractants désignés :
**CH DE GB IT NL SE**

(56) Documents cités :
**DE A 1 597 430
DE A 2 048 630
FR A 2 067 039
FR A 2 274 073
FR A 2 295 452**

**IBM TECHNICAL DISCLOSURE BULLETIN vol. 21,
no. 9, février 1979 New York US H.H. BLOEM et
al. : « Master artwork generator system », pages
3599 et 3600**

(73) Titulaire : **THOMSON-CSF
173, Boulevard Haussmann
F-75379 Paris Cedex 08 (FR)**

(72) Inventeur : **Lacombat, Michel
"THOMSON-CSF" - SCPI 173, bld Haussmann
F-75360 Paris Cedex 08 (FR)**
Inventeur : **Gerard, André
"THOMSON-CSF" - SCPI 173, bld Haussmann
F-75360 Paris Cedex 08 (FR)**

(74) Mandataire : **Lepercque, Jean et al
THOMSON-CSF SCPI 173, Bld Haussmann
F-75379 Paris Cedex 08 (FR)**

EP 0 015 789 B1

# 0 015 789

## Dispositif optique de projection en photorépétition

L'invention se rapporte à un dispositif optique de projection de motifs permettant de reproduire sur une plaquette semiconductrice recouverte d'un matériau photosensible l'image d'un objet modulateur porté par un réticule ou constitué par une fente à ouverture variable en vue de la fabrication de composants semiconducteurs, et en particulier un dispositif optique de projection dans lequel il est possible d'associer à la fonction photorépétition des fonctions différentes telles que la photocomposition ou une deuxième voie de photorépétition. Il est encore possible, selon un aspect supplémentaire de l'invention d'y associer un dispositif d'alignement des plans objets image ou encore de réaliser toutes combinaisons de ces fonctions.

Dans les dispositifs optiques de projection de l'art ancien, la photorépétition se fait par projection directe de l'image d'un objet modulateur sur la plaquette semiconductrice à insoler, en utilisant pour ce faire un objectif de projection. En général, cet objectif est réducteur, par exemple dans un rapport 1/5. Dans certaines applications on utilise des objectifs à grande distance objet-image, par exemple 600 mm ou plus. Ces objectifs conduisent à des photorépétiteurs de grande dimension. D'autre part, la photorépétition met en œuvre un grand nombre d'opérations complexes, en particulier des opérations d'alignement du réticule par rapport à la plaquette semiconductrice. Ces opérations nécessitent en général de nombreuses commutations d'éléments, qui doivent être positionnés de façon très précise. Elles tendent à ralentir le processus de transfert.

Il est connu, d'après les demandes de brevet allemand DE-A-1 597 430 et DE-A-2 048 630 de replier, à l'aide d'un miroir fixe, le trajet des rayons lumineux utilisés pour l'imagerie. Il est également connu de ces mêmes documents, ces miroirs étant partiellement transparent, de les utiliser également pour réaliser l'alignement d'un substrat avec un réticule ou masque portant des motifs à répéter sur ce substrat. Pour ce faire, une seconde source d'énergie lumineuse est mise en œuvre, de longueur d'onde différente de celle utilisée pour l'imagerie, c'est à dire l'exposition des substrats. Enfin, il est encore connu de créer deux trajets optiques et d'éclairer alternativement le réticule à l'aide de l'une ou l'autre source, respectivement pendant des périodes d'exposition et d'alignement, à l'aide d'un miroir plan pivotant et renvoyant sélectivement les rayons émis par l'une ou l'autre des sources vers le réticule. Une telle disposition est décrite dans la revue US : « IBM TECHNICAL DISCLOSURE BULLETIN », vol. 21, N° 9, Février 1979 aux pages 3599 et 3600.

Les préambules des revendications 1 et 2 reprennent l'enseignement de cette publication.

Tout en conservant l'avantage de pouvoir replier le faisceau optique sur lui-même et de permettre ainsi l'utilisation d'objectifs de grande distance objet-image, en obtenant de ce fait une certaine compacité à la machine, l'invention se fixe pour but de proposer une structure de dispositif de projection permettant en outre d'associer à la fonction photorépétition, des fonctions différentes telles que la photocomposition ou une deuxième voie de photorépétition sans autre commutation que le simple retrait d'un miroir amovible. Dans une variante de réalisation supplémentaire, par utilisation de miroirs fixes semi-transparents, un dispositif d'alignement des plans objet-image peut être associé au dispositif de projection.

L'invention a donc pour objet un dispositif optique de projection de motifs permettant de reproduire sur une plaquette semiconductrice recouverte d'un matériau photosensible ou sur un masque l'image d'au moins un objet modulateur constitué par au moins un réticule, dispositif optique de projection comprenant un objectif de projection ainsi qu'au moins une source d'énergie lumineuse pour l'illumination de chaque objet modulateur, et des moyens optiques réfléchissants comprenant au moins un miroir plan de telle sorte qu'il puisse être crée au moins un premier trajet optique et un second trajet optique ; caractérisé en ce qu'il comprend au moins des premier et second objets modulateurs associés respectivement auxdits premier et second trajets optiques et en ce que le miroir plan desdits moyens réfléchissants est amovible, déplaçable dans un plan entre deux positions définies et disposé entre les objets modulateurs et l'objectif de projection, de manière à permettre la projection alternée, suivant l'un desdits trajets optiques, sur la plaquette semiconductrice ou sur le masque, de l'image des objets modulateurs, par commutation du miroir plan amovible.

L'invention a encore pour objet un dispositif optique de projection de motifs permettant de reproduire sur une plaquette semiconductrice recouverte d'un matériau photosensible ou sur un masque l'image d'au moins un objet modulateur constitué par au moins un réticule ou une fente à ouverture variable, dispositif optique de projection comprenant un objectif de projection ainsi qu'au moins une source d'énergie lumineuse pour l'illumination de chaque objet modulateur, et des moyens réfléchissants comprenant au moins un miroir plan de telle sorte qu'il puisse être créé au moins un premier trajet optique et un second trajet optique ; caractérisé en ce qu'il comprend au moins un premier et un second objets modulateurs constitués respectivement par au moins un réticule et une fente à ouverture variable, chaque objet modulateur étant associé à un desdits trajets optiques et en ce que le miroir plan desdits moyens réfléchissants est amovible, déplaçable dans un plan entre deux positions définies et disposé entre les objets modulateurs et l'objectif de projection, de façon à permettre, conformément à une séquence préétablie, un fonctionnement en photocomposition et en photorépétition, par projection, suivant l'un desdits trajets optiques, respectivement de l'image de la fente à ouverture variable ou de

# 0 015 789

l'image d'un réticule, par commutation du miroir plan amovible.

L'invention sera mieux comprise et d'autres caractéristiques apparaîtront à l'aide de la description qui suit, en référence aux figures annexées et parmi lesquelles :

la figure 1   illustre un dispositif optique de projection multifonctions selon l'invention ;

la figure 2   illustre un dispositif optique de projection multivoies selon l'invention ;

la figure 3   est une variante du dispositif optique de projection de la figure 2, associé à un dispositif d'alignement ;

la figure 4   illustre la configuration d'un réticule ;

la figure 5   illustre une autre variante du dispositif optique de projection selon l'invention ;

la figure 6   est un exemple de réalisation concrète d'un photorépéteur dans lequel le principe à la base de l'invention a été mis en œuvre.

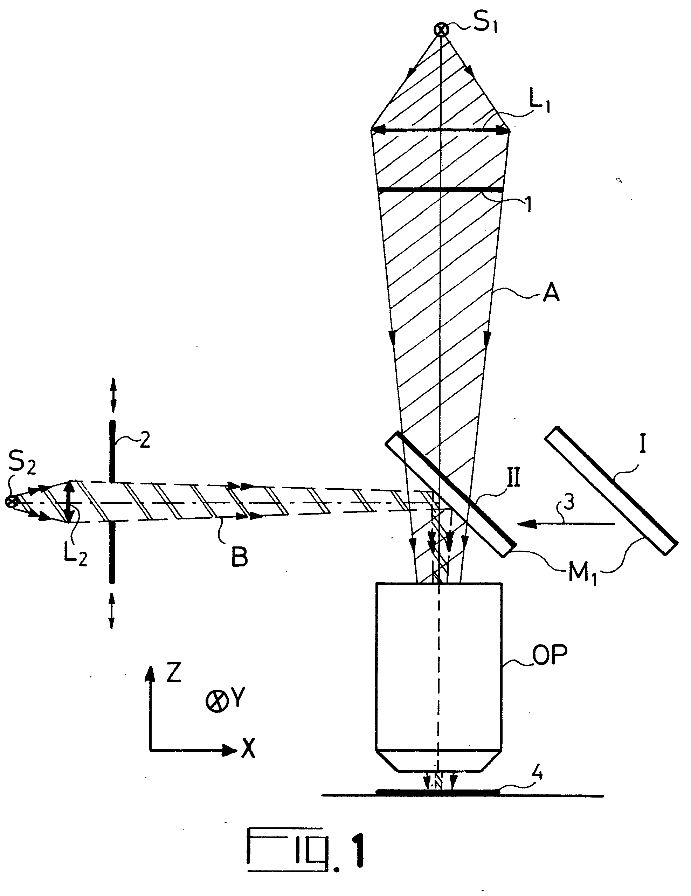

Dans la description qui va suivre, en relation avec les figures 1 à 5, les éléments communs à deux figures ou plus portent la même référence. Une seule description en sera faite.

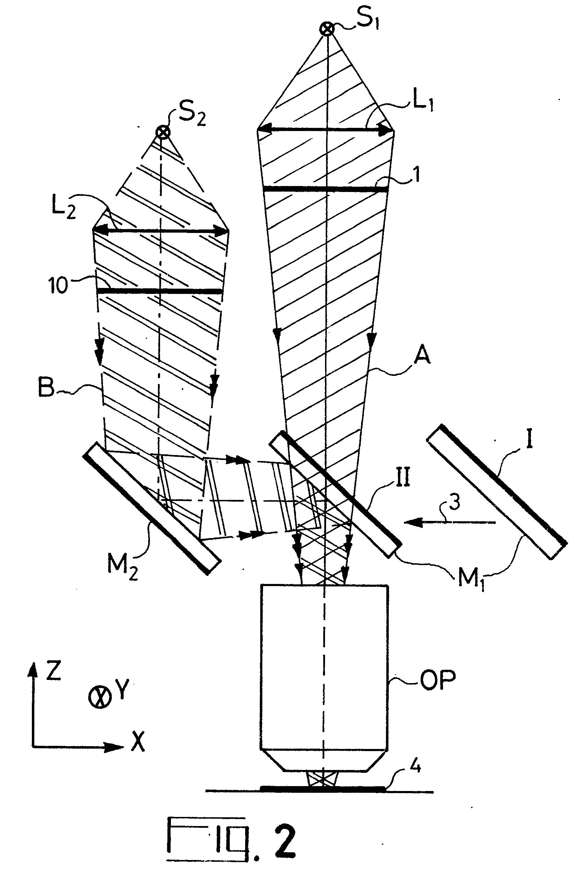

Les figures 1 et 2 sont deux exemples de réalisation de systèmes optiques de projection selon une première approche de l'invention. Ces deux réalisations comportent chacune deux voies, repérées A et B. Les voies A et B peuvent être des voies identiques de photorépétition ou des voies distinctes, par exemple la voie A une voie de photorépétition avec utilisation d'un réticule, la voie B une voie de photocomposition avec utilisation d'une fente à ouverture variable. De cette façon, le système optique de projection de l'invention peut être utilisé en photorépéteur ou en photocomposeur, ou encore, en associant les deux fonctions, pour la réalisation d'un masque où interviennent des images répétées du réticule et des interconnexions faites à partir de la fente à ouverture variable.

La figure 1 est un exemple de système optique de projection multifonctions. Un miroir plan $M_1$ peut se déplacer entre deux positions I et II. Le système optique de projection comprend les éléments habituels d'un photorépéteur de l'art ancien. En particulier, un réticule 1 est illuminé par une source $S_1$ au travers d'un condenseur $L_1$. Le faisceau résultant A est projeté par l'objectif de projection OP sur une plaquette semiconductrice 4 à insoler pour la réalisation d'un circuit intégré ou sur une plaque photosensible pour la réalisation d'un masque, lorsque le miroir est en position I. L'axe du faisceau optique A est parallèle à un axe de référence Z. Le système optique de projection comporte une seconde voie B que l'on a représentée parallèle à un axe de référence X. Une fente à ouverture variable 2 suivant l'axe Y est illuminée par une source $S_2$ au travers d'un condenseur $L_2$. Le faisceau résultant B va être intercepté par le miroir en position II et réfléchi selon l'axe optique de l'objectif OP (axe Z).

Le positionnement du miroir $M_1$ doit être précis pour que l'image projetée sur la plaquette semiconductrice 4 soit de bonne qualité. Typiquement, si on veut une précision de 0,1 μm sur la plaquette 4, le positionnement du miroir doit être reproductible avec une précision de l'ordre 0,2 seconde d'arc et 1 μm. Ces reproductibilités de positionnement sont compatibles avec l'utilisation des tables de translation disponibles dans le commerce, par exemple une table de translation du type à rouleaux croisés. Cette table a été symbolisée sur la figure 1 par le repère 3. On peut également utiliser un plateau tournant. Cette exigence étant respectée, l'invention permet le passage du système optique de projection du mode photocomposition au mode photorépétition par la simple commutation du miroir $M_1$. Au lieu de se faire suivant l'axe X, cette commutation peut également se faire selon l'axe Y.

Sur la figure 2, est illustré schématiquement d'un système optique de projection multivoies. La structure générale du système optique est analogue à celle de la figure 1. Un miroir plan supplémentaire $M_2$ replie le faisceau B sur lui-même. La fente à ouverture variable à été remplacée par un second réticule 10. Par commutation du miroir $M_1$, par exemple suivant la direction X, le masque ou la plaquette semiconductrice 4 pourront être insolés alternativement par l'image du réticule 1 (le miroir $M_1$ étant en position I) ou par l'image du réticule 10 (le miroir $M_1$ étant en position II).

Dans une variante, la voie A peut être utilisée pour une photorépétition sur masque dur (résine photo-sensible du type « photoresist »). La source $S_1$ est dans ce cas une lampe à vapeur de mercure, associée à un filtre (non représenté) permettant de sélectionner une raie particulière du spectre de la lampe. La voie B peut être utilisée pour une photorépétition sur masque à émulsion de haute résolution (par exemple du type « HRP » de la marque KODAK). La source $S_2$ est alors une lampe flash.

Les structures des figures 1 et 2 peuvent être interverties, en remplaçant par exemple la fente à ouverture variable 2 de la figure 1 par un réticule. D'autre part, on peut utiliser un miroir amovible supplémentaire, créant ainsi une troisième voie.

La figure 3 est une variante du dispositif de la figure 2 comprenant en outre un dispositif d'alignement de la plaquette semiconductrice 4 par rapport au réticule 1. Ce dispositif n'a été représenté que sur la voie B. La voie A (non représentée) peut être également associée à un tel dispositif. Dans une première phase, le réticule 10 est illuminé par la source $S_2$, le faisceau résultant 8 est réfléchi une première fois par un miroir plan semi-transparent $M_{20}$ fixe (équivalent au miroir $M_2$ de la figure 2 pour le faisceau B) et une seconde fois par le miroir mobile $M_1$ (en position II) vers l'objectif OP. Le réticule comporte, en plus des motifs à projeter, des repères 11 permettant l'alignement.

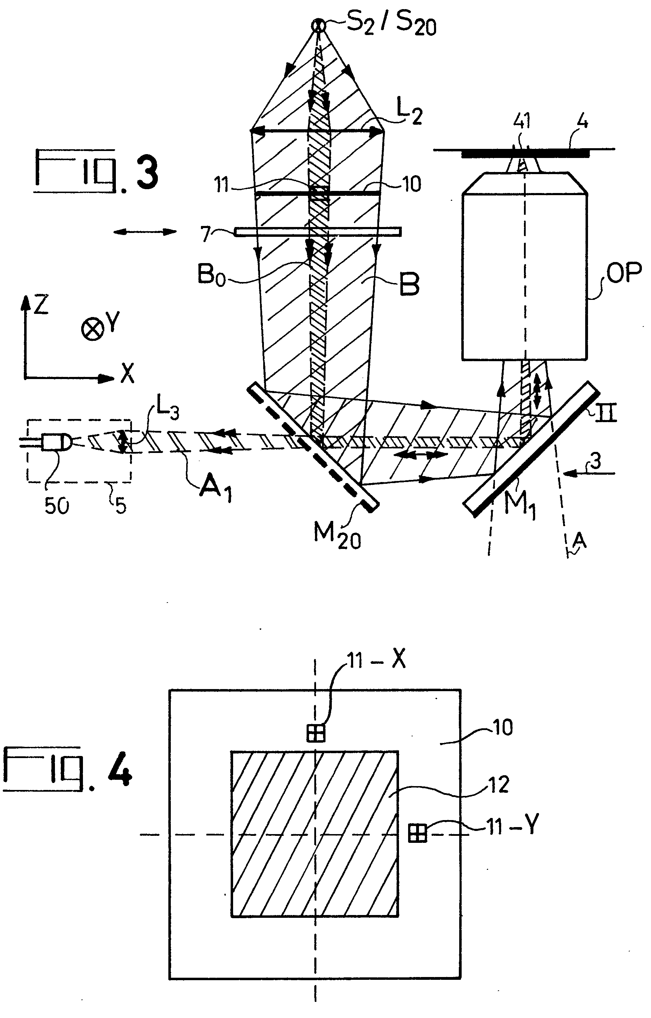

La figure 4 illustre un exemple d'un tel réticule 10 comportant une zone centrale constituée par le motif 12 à répéter. Ce réticule comporte un couple de repères 11-X, 11-Y destiné à l'alignement. Différents procédés d'alignement ont été proposés, et en particulier le procédé d'alignement décrit dans la demande de brevet français publiée sous le N° 2 388 371. A l'aide des deux repères 11-X et 11-Y, la

3

plaquette semiconductrice pourra être positionnée de façon précise par rapport aux axes X et Y et positionnée angulairement par rapport à l'axe Z.

Une source $S_{20}$ éclaire pendant la phase d'alignement les repères 11-X et 11-Y et crée le faisceau $B_0$. La position de ces repères est comparée à celle d'un couple de repères 41 portés par la plaquette semiconductrice 4.

Pour réaliser l'alignement, on utilise le retour inverse du faisceau $B_0$, dont une partie $B_1$ va être transmise par le miroir semitransparent $M_{20}$. Le faisceau transmis $A_1$, sera recueilli par un détecteur 5, comprenant une optique focalisatrice $L_3$ et un composant optoélectronique 50.

La source $S_{20}$, utilisée pendant la phase d'alignement doit avoir une longueur d'onde différente de la source d'énergie lumineuse $S_2$ pour ne pas impressionner la résine photosensible recouvrant la plaquette semiconductrice 4. On peut utiliser pour ce faire à titre d'exemple, un laser HeNe, de longueur d'onde $\lambda_2 = 6\,328$ Å pour la source $S_{20}$ et une lampe à vapeur de mercure, munie d'un filtre (non représenté sur la figure 3) pour la source $S_2$ permettant de sélectionner une raie du spectre de la lampe correspondant à la meilleure sensibilité pour l'impression de la résine photosensible, par exemple $\lambda_1 = 4\,050$ Å. L'objectif OP est corrigé pour la longueur d'onde $\lambda_1$.

Pour obtenir une image nette sur la plaquette semiconductrice, il est nécessaire d'introduire pendant la phase d'alignement dans le trajet optique, entre le réticule et l'objectif OP, des moyens optiques de correction de mise au point compensant l'écart de mise au point dû à l'emploi de rayonnements de longueurs d'onde différentes pour l'exposition de la plaquette et l'observation des repères. Ce peut être par exemple une lame 7 transparente parallèle, de bonne qualité optique ($\lambda/10$). La position dans le plan XY de la lame peut être quelconque, seule compte sa position angulaire. Sa mise en place et son retrait peuvent donc être effectués rapidement.

Dans cette version, il est avantageux que le miroir $M_1$ soit à revêtement multidiélectrique tel qu'il réfléchisse le maximum (99 % environ) d'énergie lumineuse de longueur d'onde $\lambda_1$ (dans la gamme 4 050 Å à 4 350 Å d'exposition de la plaquette semiconductrice) et soit semi-transparent à la longueur d'onde $\lambda_2$ (par exemple à 6 328 Å, utilisée pour l'alignement).

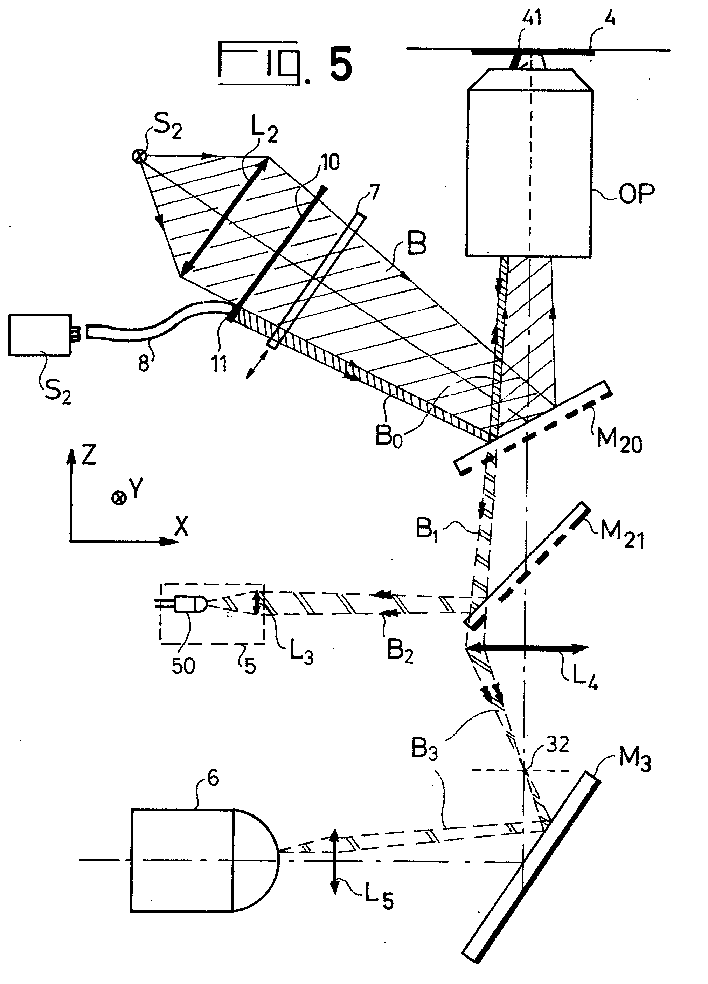

Bien que sur la figure 3, les sources $S_1$ et $S_{20}$ aient été confondues, les sources $S_1$ et $S_{20}$ peuvent également être distinctes. Les repères 11 du réticule sont en général placés en périphérie du motif à projeter. On peut donc éclairer ces repères à l'aide, par exemple, de fibres optiques. Ceci est illustré sur la figure 5. Des fibres optiques 8 transportent l'énergie lumineuse en provenance d'un laser $S_2$ vers les repères 11. Sur la figure 5 un seul repère a été représenté.

Le système optique de projection de la figure 5 (qui présente une extension de la variante de la figure 3) permet de plus une visualisation pendant la phase d'alignement, des repères portés sur la plaquette 4. La figure 5 visant plus particulièrement à illustrer cet aspect, le miroir mobile $M_1$ n'a pas été représenté pour des raisons de commodité. Il peut être placé entre le miroir $M_{20}$ et la lame 7 par exemple. Le faisceau d'alignement émergeant du réticule 10 : $B_0$, après réflexion sur un miroir plan semitransparent $M_{20}$ atteint l'objectif de projection OP et projette de ce fait l'image du repère 11 sur un repère 41 porté par la plaquette semiconductrice 4. Après réflexion et retour inverse de la lumière, une partie de ce faisceau $B_0$ est transmise en $B_1$. Le faisceau $B_1$ est lui-même réfléchi en $B_2$ par un second miroir semitransparent $M_{21}$ pour être détecté par les moyens optoélectroniques de détection 5. Le faisceau $B_2$ à son tour est transmis en partie au travers du miroir semitransparent $M_{21}$. L'image d'un point de repère 41 est conjuguée optiquement en 32, à l'aide d'une lentille convergente $L_4$. Un miroir plan fixe $M_3$ réfléchit le faisceau $B_3$ vers un tube vidicon 6 au travers d'une lentille $L_5$. Les signaux de sortie du tube vidicon peuvent être transmis aux circuits électroniques d'un téléviseur non représenté. Un opérateur pourra observer la superposition, sur un grand écran, des repères de la plaquette de silicium 4 et de l'image des repères portés par le réticule 1. Les signaux de sortie des détecteurs peuvent être transmis à des circuits d'asservissement permettant l'alignement automatique suivant deux axes X et Y. Si le miroir a été disposé entre la lame 7 et le miroir $M_{20}$, les moyens de détections 5 et de visualisation 6 peuvent être communs aux deux voies A et B.

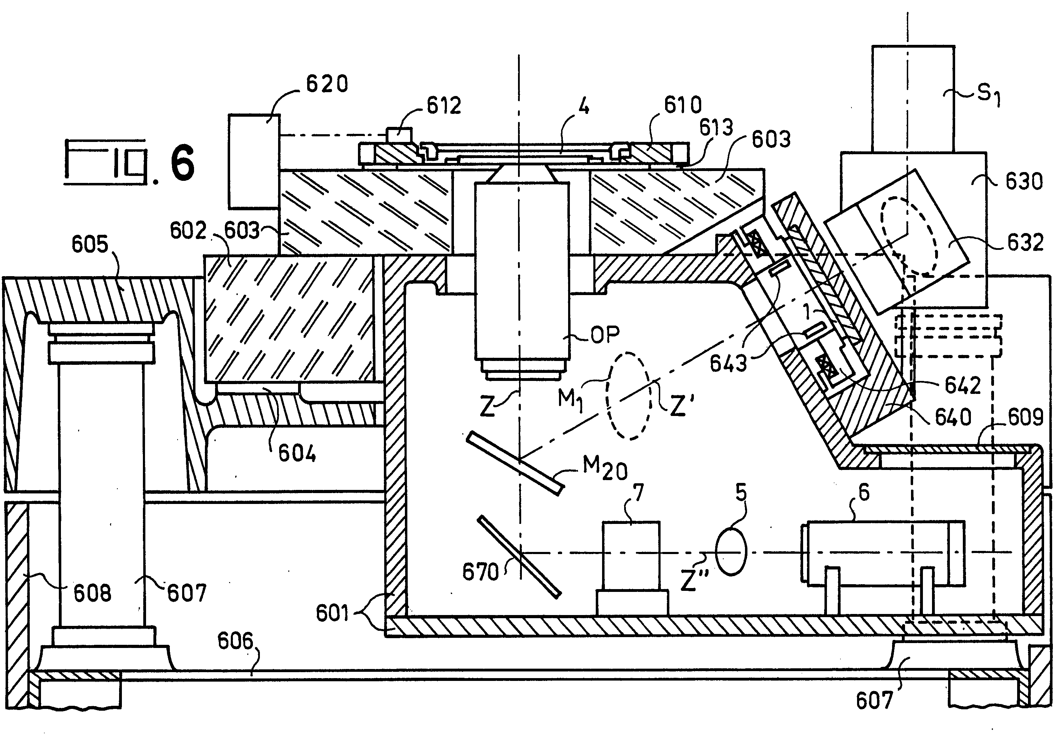

A titre d'exemple non limitatif, la figure 6 décrit une réalisation concrète d'un photorépéteur dans lequel l'invention peut être mise en œuvre, photorépéteur associé à un dispositif d'alignement. Sur cette figure une seule des voies, équivalente aux voies A et B précédemment décrites, a été représentée.

Il comporte un bâti inférieur 608 et un bâti supérieur 605. Le bâti supérieur 605 repose sur une platine 606, solidaire au bâti inférieur 608 par l'intermédiaire de colonnes 607 d'amortisseurs à air. Le bâti supérieur 605 supporte, par l'intermédiaire d'un patin amortisseur 604, un marbre porteur 602. Ce marbre porteur 602 constitue le socle d'un marbre de référence 603 ; il supporte également une table de translation XY non détaillée. Le marbre 603 supporte un plateau correcteur 610, susceptible d'être déplacé suivant deux axes orthogonaux X et Y. L'amplitude de ces déplacements est de l'ordre d'une dizaine de microns par rapport à la table XY. Ces déplacements sont commandés par deux groupes de céramiques piézoélectriques agissant respectivement suivant les axes X et Y. Les déplacements se font sous la commande de deux unités d'interférométrie à mouvement croisé. Seuls l'interféromètre 620 et le miroir de mesure 612, suivant l'axe X, ont été représentés. Ce procédé est du domaine de l'art connu et les circuits de commande n'ont pas été représentés sur la figure 1. Un ensemble optique 601 est solidaire du marbre de référence 603. Les différents composants de cet ensemble optique 601 sont, notamment, un objectif de projection OP et au moins une embase porte-réticule 642. L'embase porte-réticule 642 est un commutateur de réticule sur lequel est fixé le réticule 1. Un manipulateur XY et θ : 640 permet d'aligner le réticule 1 par rapport à des repères machine 643. La plaquette semiconductrice à insoler 4, recouverte d'une couche de résine photosensible est posée sur le plateau correcteur 10. Ce plateau correcteur peut glisser dans le plan du marbre de référence sur des coussins d'air 613. L'objectif de projection OP peut se déplacer suivant l'axe Z. Il est muni de tous les organes de réglage conventionnels (qui ne sont pas représentés sur la figure 1). Le réticule 1 est susceptible d'être déplacé suivant deux axes orthogonaux X et Y, et en rotation θ dans le plan défini par X et Y. Sur ce réticule sont inscrits les motifs à projeter sur la plaquette de silicium 4, ainsi que des motifs repères. L'ensemble optique 601, réalisé selon l'invention comporte un miroir semitransparent $M_{20}$, un deuxième miroir 670 et une optique de compensation 7, des moyens détecteurs d'alignement 5 et un tube vidicon 6. L'ensemble optique comporte également une fenêtre d'accès 609 et une unité d'illumination 630, comprenant un condenseur et un miroir 632 ainsi qu'une source d'énergie lumineuse $S_1$. Un troisième miroir $M_1$, mobile, associé avec éventuellement d'autres miroirs fixes, peut être disposé sur le trajet du faisceau d'exposition pour d'une part, occulter le faisceau provenant de l'embase porte-réticule 642 et, d'autre part, projeter un faisceau lumineux en provenance d'un autre porte-réticule ou d'une fente mobile comme décrit en relation avec les figures 1 et 2.

L'invention n'est pas limitée aux réalisations qui viennent d'être décrites. On peut notamment combiner la réalisation de la figure 5 avec l'une des figures 1 ou 2. On obtient alors un système optique de projection multifonctions et/ou multivoies associé à un dispositif d'alignement. Malgré ses multiples possibilités, cet appareil se présente sous une forme extrêmement compacte.

Les moyens optiques réfléchissants comprenant des miroirs selon l'invention ont donc un triple rôle :
— ils permettent de replier le chemin optique et rendent le système optique de projection compact même avec des distances objet-image de 1 mètre.
— ils permettent de placer le réticule et la plaquette semiconductrice dans un plan horizontal ou incliné, ce qui favorise les manipulations simples.
— enfin, ils permettent la réalisation d'un système optique de projection combinant plusieurs fonctions et/ou plusieurs voies sans nécessiter de manipulations complexes ou de nombreuses commutations délicates d'éléments. En outre, un dispositif d'alignement automatique muni d'une visualisation simultanée peut être associé simplement au système optique de projection.

Les principales caractéristiques des éléments nécessaires à la réalisation concrète de l'invention, ainsi que quelques exemples non limitatifs d'éléments disponibles dans le commerce sont indiqués dans le tableau ci-dessous :

— objectif de projection ...................................... marque CERCO, référence 744, rapport de réduction 1/5

— source d'illumination d'alignement .............. laser HeNe, $\lambda_2 = 6\,328$ Å

— source d'illumination pour la projection .... lampe au mercure à spectre étendu, associée à des filtres pour sélectionner la raie $\lambda_1 = 4\,050$ Å

— moyens optoélectroniques de détection ..... photodiodes : marque EGG, type SGD 100 ou HAD 1 000A ou photomultiplicateur marque RTC, type XP 1 117 (miniphotomultiplicateur)

— miroirs fixes ou amovibles ............................ planéité : au moins $\lambda/10$. Traitement mono-couche ou multi-couche pour éviter une variation de coefficient de réflexion

— miroirs plans semi-transparents ................... miroir multidiélectrique :
— coefficient de réflexion 0,99 dans la gamme : $4\,050$ Å $< \lambda_1 < 4\,350$ Å
— coefficient de transmission d'environ 0,5 pour $\lambda = 6\,328$ Å
— seule, la réflexion est utilisée pour l'imaginerie (pour éviter les aberrations)
— traitement de surface et planéité
— identique aux miroirs plans fixes.

Les autres composants (lentilles, etc...) sont choisis parmi ceux habituellement utilisés pour les photorépéteurs de l'art connu.

**Revendications**

1. Dispositif optique de projection de motifs permettant de reproduire sur une plaquette semiconductrice (4) recouverte d'un matériau photosensible ou sur un masque l'image d'au moins un objet modulateur constitué par au moins un réticule, dispositif optique de projection comprenant un objectif de projection (OP) ainsi qu'au moins une source d'énergie lumineuse pour l'illumination de chaque objet modulateur, et des moyens optiques réfléchissants comprenant au moins un miroir plan ($M_1$) de telle sorte qu'il puisse être créé au moins un premier trajet optique (A) et un second trajet optique (B) ; caractérisé en ce qu'il comprend au moins des premier (1) et second (2) objets modulateurs associés respectivement auxdits premier (A) et second (B) trajets optiques et en ce que le miroir plan ($M_1$) desdits moyens réfléchissants est amovible, déplaçable dans un plan entre deux positions définies et disposé entre les objets modulateurs et l'objectif de projection, de manière à permettre la projection alternée, suivant l'un desdits trajets optiques (A, B) sur la plaquette semiconductrice (4) ou sur le masque, de l'image des objets modulateurs, par commutation du miroir plan amovible ($M_1$).

2. Dispositif optique de projection de motifs permettant de reproduire sur une plaquette semiconductrice (4) recouverte d'un matériau photosensible ou sur un masque l'image d'au moins un objet modulateur constitué par au moins un réticule ou une fente à ouverture variable, dispositif optique de projection comprenant un objectif de projection (OP) ainsi qu'au moins une source d'énergie lumineuse pour l'illumination de chaque objet modulateur, et des moyens réfléchissants comprenant au moins un miroir plan ($M_1$) de telle sorte qu'il puisse être créé au moins un premier trajet optique (A) et un second trajet optique (B) ; caractérisé en ce qu'il comprend au moins un premier et un second objets modulateurs constitués respectivement par au moins un réticule (1) et une fente à ouverture variable (2), chaque objet modulateur étant associé à un desdits trajets optiques et en ce que le miroir plan ($M_1$) desdits moyens réfléchissants est amovible, déplaçable dans un plan entre deux positions définies et, disposé entre les objets modulateurs et l'objectif de projection, de façon à permettre, conformément à une séquence préétablie, un fonctionnement en photocomposition et en photorépétition, par projection, suivant l'un desdits trajets optiques, respectivement de l'image de la fente à ouverture variable (2) ou de l'image d'un réticule (1), par commutation du miroir plan amovible ($M_1$).

3. Dispositif selon l'une quelconque des revendications 1 ou 2, caractérisé en ce que le miroir plan amovible ($M_1$) est rendu solidaire d'une table de translation ou un plateau tournant (3) déplaçant ledit miroir dans un plan (XY).

4. Dispositif selon l'une quelconque des revendications 1 ou 2, caractérisé en ce qu'il comporte en outre, lesdites sources ($S_1$, $S_2$) destinées à l'illumination étant d'une première longueur d'onde et étant activées pendant des phases d'exposition, un dispositif d'alignement par association optique de repères de référence (11) portés par le réticule (10) avec des repères (41) portés sur la plaquette semiconductrice (4) et en ce que le dispositif d'alignement comprend une source supplémentaire ($S_{20}$) d'une seconde longueur d'onde, activée pendant des phases d'alignement et au moins un premier miroir plan fixe ($M_{20}$) associé à au moins un des trajets optiques (B) et partiellement transparent de telle sorte que les faisceaux lumineux (B, $B_0$) des premières et seconde longueurs d'ondes soient réfléchis vers l'objectif de projection (OP) et que, en retour inverse de la lumière, le faisceau lumineux de seconde longueur d'onde soit transmis sélectivement ($B_1$) vers des moyens optoélectroniques de détection (5).

5. Dispositif selon la revendication 4, caractérisé en ce que le premier miroir plan fixe, partiellement transparent ($M_{20}$), est un miroir à revêtement multidiélectrique de telle sorte que ce miroir ait un coefficient de réflexion voisin de 1 pour la première longueur d'onde et un coefficient de transmission voisin de 0,5 pour la seconde longueur d'onde.

6. Dispositif selon la revendication 4, caractérisé en ce que le dispositif d'alignement comprend au moins un second miroir plan fixe ($M_{21}$) associé à un des trajets optiques (B) et partiellement transparent, miroir réfléchissant une partie ($B_2$) de l'énergie lumineuse ($B_1$) transmise par le premier miroir vers lesdits moyens optoélectroniques de détection (5) et transmettant une autre partie ($B_3$) de l'énergie lumineuse vers des moyens de visualisation (6).

7. Dispositif selon la revendication 6, caractérisé en ce que les moyens de visualisation (6) comprennent une caméra de télévision.

8. Dispositif selon la revendication 4, caractérisé en ce que le dispositif d'alignement comprend, l'objectif étant corrigé pour la première longueur d'onde, des moyens de correction (7) de mise au point compensant l'écart de mise au point et de grandissement dû à l'utilisation de deux rayonnements de longueur d'onde différente.

9. Dispositif selon l'une quelconque des revendications 4 à 8, caractérisé en ce que les moyens optoélectroniques de détection (5) et les moyens de visualisation (6) sont communs à plusieurs trajets optiques (A, B).

**Claims**

1. Optic device for the projection of patterns allowing the reproduction of the image of at least one modulating object formed by at least one reticle on a semiconductor chip (4) covered by a photo-sensitive material or on a mask, the optic projection device comprising a projection objective (OP) as well as at least one light energy source for illumination of each modulating object, and reflecting optic means comprising at least one plane mirror ($M_1$) so that at least one first optic path (A) and a second optic path (B) can be formed ; characterized in that it comprises at least first (1) and second (2) modulating objects respectively associated with the first (A) and second (B) optic paths, and in that the plane mirror ($M_1$) of

**0 015 789**

the reflecting means is removable, displaceable between two defined positions in a plane and located between the modulating objects and the projection objective, in a manner to allow the alternating projection of the image of the modulating objects along one of the optic paths (A, B) onto the semiconductor chip (4) or onto the mask, by commutation of the removable plane mirror ($M_1$).

2. Optic device for the projection of patterns allowing the reproduction of the image of at least one modulating object formed by at least one reticle or variable opening slot on a semiconductor chip (4) covered by a photo-sensitive material or on a mask, the optic projection device comprising a projection objective (OP) as well as at least one light energy source for illumination of each modulating object and reflecting means comprising at least one plane mirror ($M_1$) so that at least one first optic path (A) and one second optic path (B) can be formed ; characterized in that it comprises at least one first and one second modulating object respectively formed by at least one reticle (1) and one variable opening slot (2), each modulating object being associated with one of the optic paths, and in that the plane mirror ($M_1$) of the reflecting means is removable, displaceable between two defined positions in a plane and located between the modulating objects and the projection objective, in a manner to allow a photo-composition and photo-repetition operation in accordance with a predetermined sequence by projection of the image of the variable opening slot (2) or of the image of a reticle (1), respectively, along one of said optic paths, by commutation of the removable plane mirror ($M_1$).

3. Device in accordance with any of claims 1 and 2, characterized in that the removable plane mirror ($M_1$) is joined with a translational table or rotating plate (3) displacing said mirror within a plane (XY).

4. Device in accordance with any of claims 1 and 2, characterized in that, said sources ($S_1$, $S_2$) for illumination having a first wave length and being activated during exposure steps, it further comprises an aligning device for aligning by optic association of reference marks (11) carried by the reticle (10) with marks (41) carried by the semiconductor chip (4), and in that the aligning device comprises an additional source ($S_{20}$) of a second wave length which is activated during the alignment steps and at least one first stationary plane mirror ($M_{20}$) associated with at least one of the optic paths (B) and being partially transparent so that the light beams (B, $B_0$) of the first and second wave lengths are reflected towards the projection objective (OP), and that the light beam of the second wave length is selectively transmitted ($B_1$) towards opto-electronic detection means (5) on the inverted return path of the light.

5. Device in accordance with claim 4, characterized in that the first stationary plane mirror which is partially transparent ($M_{20}$) is a mirror having a multi-dielectric coating so that this mirror has a reflection coefficient which is approximately 1 for the first wave length and a transmission coefficient which is approximately 0,5 for the second wave length.

6. Device in accordance with claim 4, characterized in that the aligning device comprises at least one second plane stationary mirror ($S_{21}$) associated with one of the optic paths (B) and which is partially transparent, said mirror reflecting part ($B_2$) of the light energy ($B_1$) transmitted by the first mirror towards said opto-electronic detection means (5) and transmitting another part ($B_3$) of the light energy towards visualization means (6).

7. Device in accordance with claim 6, characterized in that the visualization means (6) comprise a television camera.

8. Device in accordance with claim 4, characterized in that, the objective being corrected for the first wave length, the aligning device comprises focusing correction means (7) compensating for the focusing and magnification errors resulting from the use of two radiations having different wave lengths.

9. Device in accordance with any of claims 4 to 8, characterized in that the opto-electronic detection means (5) and the visualization means (6) are common to a plurality of optic paths (A, B).

**Ansprüche**

1. Optische Vorrichtung zur Projektion von Motiven, die es ermöglicht, auf einem mit einem photoempfindlichen Material bedeckten Halbleiterplättchen (4) oder auf einer Maske die Abbildung wenigstens eines modulierenden Objektes zu reproduzieren, das durch wenigstens eine Fadenkreuzplatte gebildet ist, wobei die optische Projektionsvorrichtung ein Projektionsobjektiv (PO) sowie wenigstens eine Lichtenergiequelle zur Beleuchtung jedes modulierenden Objektes und reflektierende optische Einrichtungen enthält, zu denen wenigstens ein ebener Spiegel ($M_1$) gehört, so daß wenigstens ein erster optischer Weg (A) und ein zweiter optischer Weg (B) geschaffen werden ; dadurch gekennzeichnet, daß sie wenigstens ein erstes (1) und ein zweites (2) modulierendes Objekt umfaßt, von denen das erste dem ersten optischen Weg (A) und das zweite dem zweiten optischen Weg (B) zugeordnet ist, und daß der ebene Spiegel ($M_1$) der reflektierenden Einrichtungen entfernbar und in einer Ebene zwischen zwei definierten Stellungen verschiebbar sowie zwischen den modulierenden Objekten und dem Projektionsobjektiv angeordnet ist, so daß die abwechselnde Projektion der Abbildung der modulierenden Objekte durch Umschalten des ebenen entfernbaren Spiegels ($M_1$) entlang einem der optischen Wege (A, B) auf das Halbleiterplättchen (4) oder auf die Maske ermöglicht wird.

2. Optische Vorrichtung zum Projizieren von Motiven, die es gestattet, auf einem mit einem photoempfindlichen Material bedeckten Halbleiterplättchen (4) oder auf einer Maske die Abbildung wenigstens eines modulierenden Objektes zu projizieren, welches aus wenigstens einer Fadenkreuz-

7

platte oder einem Schlitz mit variabler Öffnung gebildet ist, wobei die optische Projektionsvorrichtung ein Projektionsobjektiv (OP) sowie wenigstens eine Lichtenergiequelle zur Beleuchtung jedes modulierenden Objektes und reflektierende Einrichtungen umfaßt, zu denen wenigstens ein ebener Spiegel ($M_1$) gehört, so daß wenigstens ein erster optischer Weg (A) und ein zweiter optischer Weg (B) geschaffen werden können ; dadurch gekennzeichnet, daß sie wenigstens ein erstes und ein zweites modulierendes Objekt umfaßt, von denen das erste durch wenigstens eine Fadenkreuzplatte (1) und das zweite durch einen Schlitz mit variabler Öffnung (2) gebildet ist, wobei jedes modulierende Objekt einem der optischen Wege zugeordnet ist, und daß der ebene Spiegel ($M_1$) der reflektierenden Einrichtungen entfernbar und in einer Ebene zwischen zwei definierten Stellungen verfügbar sowie zwischen den modulierenden Objekten und dem Projektionsobjektiv angeordnet ist, so daß es ermöglicht wird, gemäß einer zuvor festgelegten Folge eine Photokompositions- und Photowiederholungsfunktion durch Projektion der Abbildung des Schlitzes mit variabler Öffnung (2) oder der Abbildung der Fadenkreuzplatte (1) über einen der optischen Wege durch Umschalten des entfernbaren ebenen Spiegels ($M_1$) zu erhalten.

3. Vorrichtung nach Anspruch 1 oder 2, dadurch gekennzeichnet, daß der entfernbare ebene Spiegel ($M_1$) fest verbunden ist mit einem Translationstisch oder einer Drehplatte (3), welche den Spiegel in einer Ebene (XY) verschiebt.

4. Vorrichtung nach Anspruch 1 oder 2, dadurch gekennzeichnet, daß sie ferner, wenn die genannten Quellen ($S_1$, $S_2$) für die Beleuchtung eine erste Wellenlänge aufweisen und während Belichtungsphasen aktiviert werden, eine Vorrichtung zum Ausrichten durch optische Zuordnung von Bezugsmarken (11), welche die Fadenkreuzplatte (10) trägt, zu Markierungen (41), welche das Halbleiterplättchen (4) trägt, umfaßt und daß die Ausrichtvorrichtung eine zusätzliche Quelle ($S_{20}$) einer zweiten Wellenlänge umfaßt, die während der Ausrichtphasen aktiviert wird, und wenigstens einen ersten ebenen, feststehenden Spiegel ($M_{20}$) aufweist, der wenigstens einem der optischen Wege (B) zugeordnet und teildurchlässig ist, so daß die Lichtbündel (B, $B_0$) der ersten und der zweiten Wellenlänge zu dem Projektionsobjektiv (OP) hin reflektiert werden und daß auf dem umgekehrten Rückweg des Lichtes das Lichtbündel der zweiten Wellenlänge selektiv ($B_1$) zu optoelektronischen Detektionsmitteln (5) durchgelassen wird.

5. Vorrichtung nach Anspruch 4, dadurch gekennzeichnet, daß der erste ebene, feststehende Spiegel ($M_{20}$), der teildurchlässig ist, ein Spiegel mit multidielektrischer Beschichtung ist, so daß dieser Spiegel einen Reflektionskoeffizienten aufweist, der für die erste Wellenlänge ungefähr gleich 1 ist, und einen Transmissionskoeffizienten aufweist, der für die zweite Wellenlänge ungefähr gleich 0,5 ist.

6. Vorrichtung nach Anspruch 4, dadurch gekennzeichnet, daß die Ausrichtvorrichtung wenigstens einen zweiten ebenen, feststehenden Spiegel ($M_{21}$) aufweist, der einem der optischen Wege (B) zugeordnet und teildurchlässig ist, wobei dieser Spiegel einen Teil ($B_2$) der Lichtenergie ($B_1$), den der erste Spiegel durchläßt, zu den optoelektronischen Detektionsmitteln (5) reflektiert und einen anderen Teil ($B_3$) der Lichtenergie zu einer Sichtdarstellungseinrichtung (6) durchläßt.

7. Vorrichtung nach Anspruch 6, dadurch gekennzeichnet, daß die Sichtdarstellungseinrichtung (6) eine Fernsehkamera umfaßt.

8. Vorrichtung nach Anspruch 4, dadurch gekennzeichnet, daß die Ausrichtvorrichtung bei einem für die erste Wellenlänge korrigierten Objektiv Korrekturmittel (7) zur Scharfeinstellung umfaßt, welche den Scharfeinstellungsfehler und den Vergrößerungsfehler kompensieren, welche auf der Verwendung von zwei Strahlungen unterschiedlicher Wellenlänge beruhen.

9. Vorrichtung nach einem der Ansprüche 4 bis 8, dadurch gekennzeichnet, daß die optoelektronischen Detektionsmittel (5) und die Sichtdarstellungseinrichtung (6) mehreren optischen Wegen (A, B) gemeinsam sind.

Fig. 1

$$\boxed{\mathsf{Fig.}\ 2}$$

Fig. 3

Fig. 4

Fig. 5

Fig. 6